Europäisches Patentamt

European Patent Office

Office européen des brevets

(11) Publication number: **0 116 464 B1**

# EUROPEAN PATENT SPECIFICATION

(45) Date of publication of patent specification: **02.05.91**   (51) Int. Cl.⁵: **G06F 11/20**

(21) Application number: **84300802.0**

(22) Date of filing: **08.02.84**

(54) A semiconductor memory device.

(30) Priority: **08.02.83 JP 18027/83**

(43) Date of publication of application:
**22.08.84 Bulletin 84/34**

(45) Publication of the grant of the patent:
**02.05.91 Bulletin 91/18**

(84) Designated Contracting States:
**DE FR GB**

(56) References cited:
**EP-A- 0 034 070**
**EP-A- 0 041 406**

(73) Proprietor: **FUJITSU LIMITED**
**1015, Kamikodanaka Nakahara-ku**
**Kawasaki-shi Kanagawa 211(JP)**

(72) Inventor: **Yoshida, Masanobu**
**3-3-3, Suehiro**
**Kawaguchi-shi Saitama 332(JP)**
Inventor: **Itano, Kiyoshi**
**878, Shimonoge Takatsu-ku**
**Kawasaki-shi Kanagawa 213(JP)**

(74) Representative: **Fane, Christopher Robin King**
**et al**
**HASELTINE LAKE & CO. Hazlitt House 28**
**Southampton Buildings Chancery Lane**
**London, WC2A 1AT(GB)**

## Description

The present invention relates to a semiconductor memory device, for example to a programmable read only semiconductor memory device (PROM) having a facility for storing predetermined read only data, known as an "electronic signature", relating to attributes of the memory device.

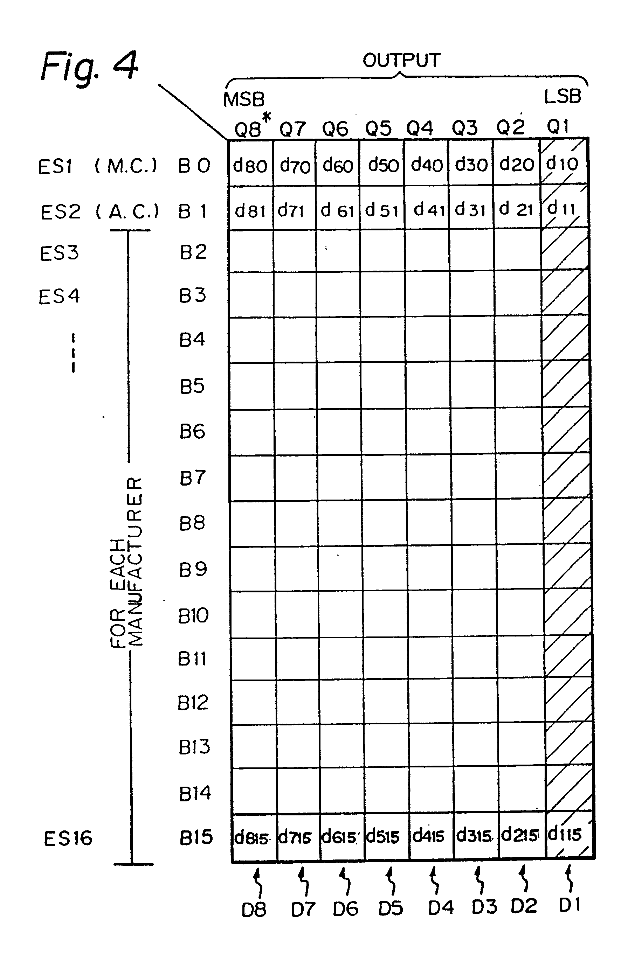

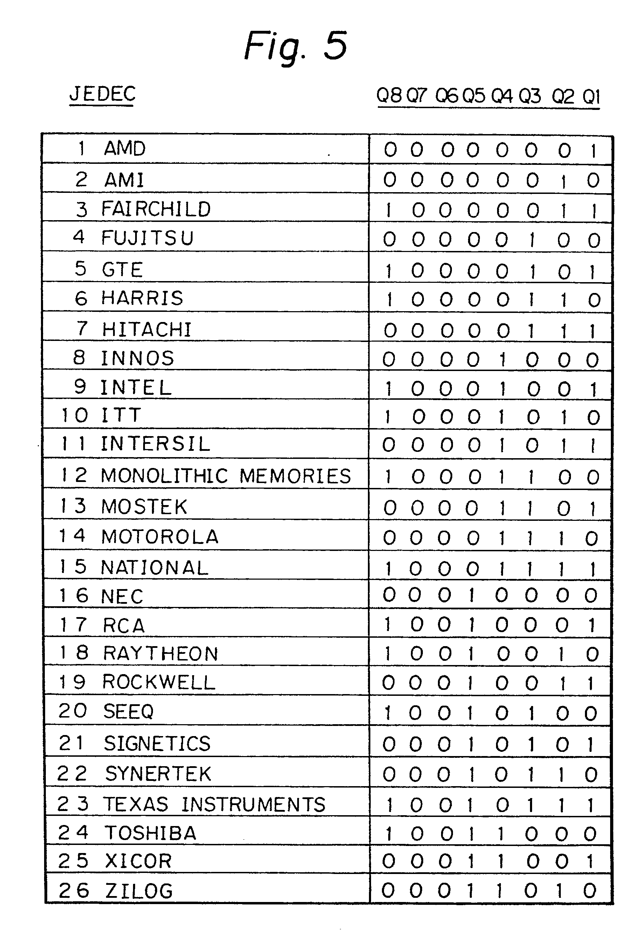

Recently, the JEDEC (Joint Electron Device Engineering Council, which is a subordinate facility of the United States Electronic Industrial Association (EIA), proposed the use of so-called electronic signatures. According to these proposals, the electronic signatures (including such data as manufacturers' codes or programming algorithm numbers) are written into specific ROM areas of an erasable and programmable read only semiconductor memory device (EPROM) during its manufacture, so that in subsequent use the signature data can be read out by applying a specific signal to a specific terminal of the EPROM. The precise nature of the signature data, such as, for instance, the manufacturers' codes, is described later in more detail with reference to the accompanying Figs. 4 and 5.

In an EPROM, in order to improve the production yield of chips, a redundancy structure may be employed so that a redundant circuit can replace a faulty circuit. Such redundancy techniques are disclosed in, for example 1981 IEEE International Solid-State Circuits Conference, ISSCC 81/Wednesday, February 18, 1981/BALL ROOMS A-B/3:15 P.M., pp 80-81, and ISSCC 82/Thursday, February 11, 1982/CONTINENTAL BALL ROOMS 1-4/10:45 A.M., pp 112-113, and in EP-A-0034070.

It is desirable to provide for the storage of electronic signature data in ROM parts of a semiconductor memory device, including a redundancy block, without taking up too much memory space.

According to an embodiment of the present invention, there is provided a semiconductor memory device comprising a plurality of primary memory blocks, for storing data words in such a manner that respective bits of each word are stored in different memory blocks of the plurality so that a stored data word can be read out in parallel form from respective output points of those memory blocks, and a redundancy memory block; the device being selectively programmable to cause the redundancy block to be used in place of any one of the primary memory blocks that is found to be faulty;

characterized in that the said primary and redundancy memory blocks contain, stored in respective ROM parts thereof lying on one wordline of the memory device, predetermined signature data comprising a plural number m of original data words, each of n data bits, stored in the form of n composite data words, each made up of m data bits taken respectively from the said original data words, the said n composite data words being stored respectively in the said primary memory blocks, and all of the said n composite data words being stored in the said redundancy block, and in that the device includes signature reading means for accessing data stored in the said ROM parts in such a manner as to read out a selected one of the original data words, the device being such that when programmed to cause the redundancy block to be used, in place of a faulty one of the primary memory blocks, the signature reading means is thereby modified so that, when in operation, it takes from the ROM part of the redundancy memory block that bit of the selected original data word that was stored in the ROM part of the said faulty block.

Reference will now be made, by way of example, to the accompanying drawings, wherein:

Figure 1 is a block diagram illustrating an EPROM according to an embodiment of the present invention;

Figure 2 is a circuit diagram of parts of the EPROM of Figure 1;

Figure 3 is a block diagram illustrating how electronic signature data is stored in the EPROM of Figure 2;

Figure 4 is a table showing a data format for the electronic signature data proposed by JEDEC;

Figure 5 is a table of manufacturers' codes;

Figure 6 is a table for explaining the operation of a part of the EPROM shown in Figure 2;

Figures 7, 8 and 9 are circuit diagrams of respective parts of the EPROM shown in Figure 2;

Figures 10 and 11 are circuit diagrams of further respective parts of the EPROM of Figure 1;

Figure 12 is a block diagram illustrating how electronic signature data is stored in an EPROM according to another embodiment of the present invention; and

Figure 13 is a circuit diagram illustrating a part of the EPROM of Figure 12.

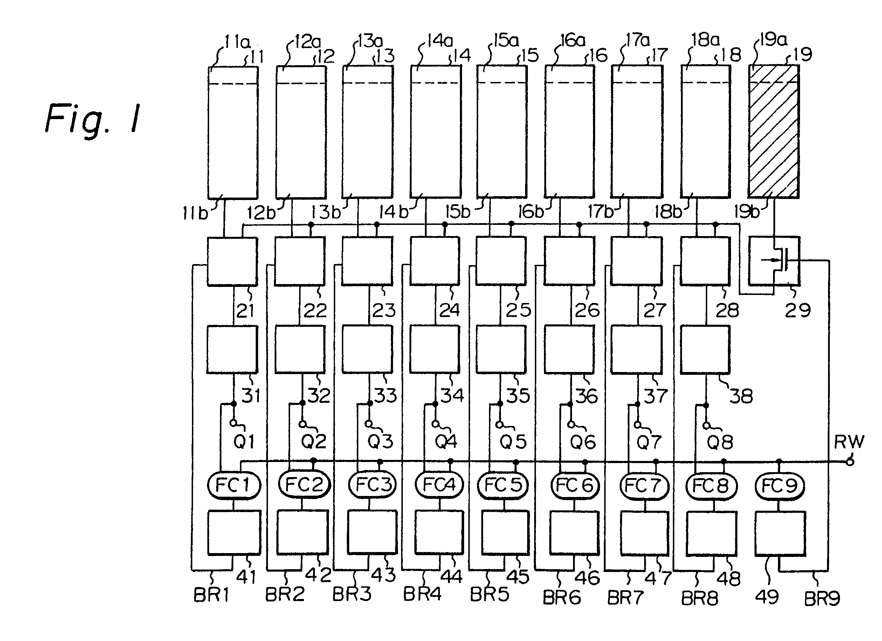

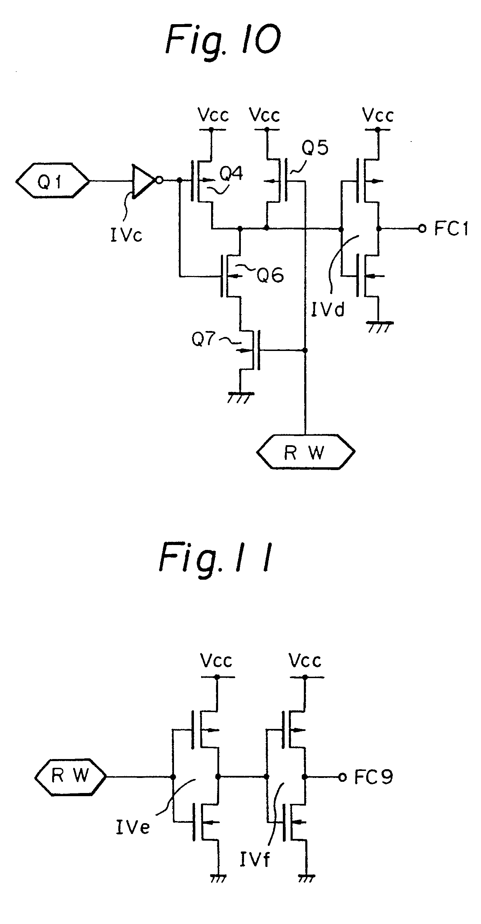

Figure 1 is a block diagram of an 8-bit parallel output EPROM having a redundancy memory cell block. In the EPROM shown in Figure 1, primary memory cell blocks 11 to 18 are connected to respective output terminals Q1 to Q8 by way of respective switching circuits 21 to 28 and respective output buffers 31 to 38. The memory cell block 19 is a redundancy memory cell block which is connected by way of a switching circuit 29 to all of the switching circuits 21 to 28, so as to be capable of being used in place of any one of the primary memory blocks that is found to be faulty. The switching of each of the switching circuits 21 through 29 is controlled by a control signal BRi, where i = 1, 2, ..., or 9, from control signal generating circuits 41 to 49. Each of the control signal generating circuits 41 to 49, produces a control signal BRi in dependence upon the conductive/nonconductive state of a fuse provided therein (not shown in Figure 1 but described in detail later with reference to Figure 9). In order to selectively program the EPROM to replace a faulty memory cell block among the memory cell blocks 11 to 18 with the redundancy memory cell block 19, a fuse in the control signal generating circuit corresponding to that faulty memory cell block is blown by one of the fuse-blowing signals FC1 to FC8. The fuse in the control signal generating circuit 49 corresponding to the redundancy memory cell block 19 is also blown by a fuse-blowing signal FC9. The fuse-blowing signals FC1 to FC8 are generated in response to a replacing signal RW and respective primary block selecting signals applied to the output terminals Q1 to Q8.

The memory cell blocks 11 to 19 have specific areas (ROM parts) 11a, 12a, 13a, ..., and 19a, respectively, for storing electronic signatures (also referred to as silicon signatures). The remaining areas 11b, 12b, .., and 19b of the memory cell blocks 11 to 19, respectively, consist of programmable and erasable read only memory (EPROM) cells.

When the redundancy memory cell block 19 is used in place of a faulty memory cell block the correct electronic signature data contained in the ROM part of that faulty memory cell block can be read out instead from the specific area (ROM part) 19a in the redundancy memory cell block 19, as later described in detail.

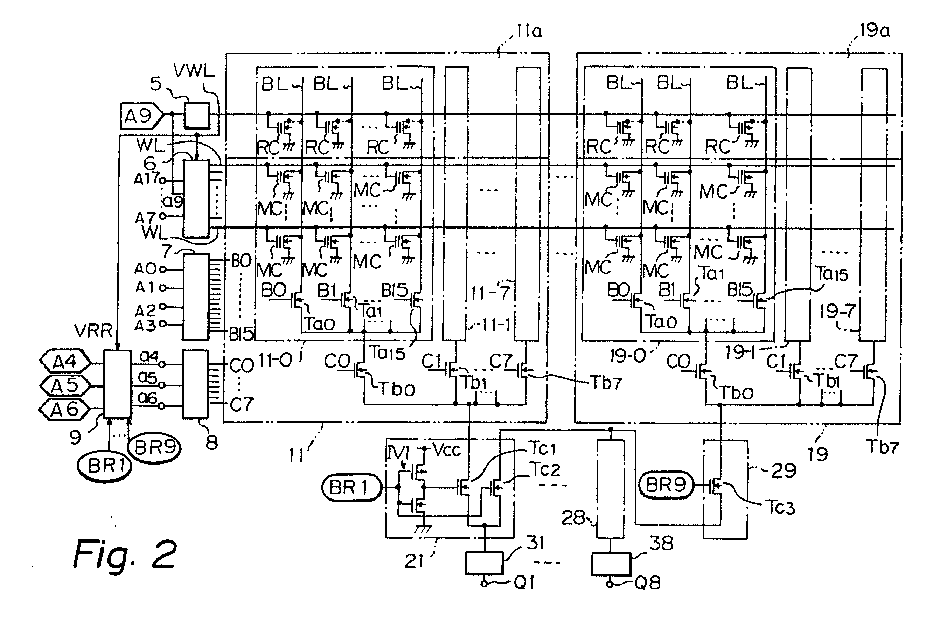

In Figure 2, the construction of the memory cell block 11, the redundancy memory cell block 19, and the switching circuits 21 and 29 in the EPROM shown in Figure 1 is illustrated in more detail. In the memory cell block 11, a plurality of word lines WL and a plurality of bit lines BL extend orthogonally to one another. At each intersection of a word line WL and a bit line BL, an erasable and programmable read-only memory cell MC is provided. In the specific area 11a, there is provided a virtual word line VWL extending in parallel with the word lines. At each intersection of the virtual word line VWL and a bit line BL, a read-only memory cell RC is provided. The read-only memory cells RC are adapted to store data of the electronic signatures by connecting or not connecting them to their respective bit lines BL. Examples of the nature of the electronic signature data will be given later with reference to Figs. 4 and 5. The virtual word line VWL is connected to a signal detecting circuit 5 which detects a virtual word line selecting signal applied to an address input terminal $A_9$ and then activates the virtual word line VWL to permit reading of the electronic signatures from the read only memory cells RC. Each word line WL is connected to a row decoder circuit 6 which is operative to deactivate all of the word lines, when the signal on the virtual word line VWL becomes "H", by setting all the word lines WL to logic "L".

The memory cell block 11 is divided into eight sun-blocks 11-0, 11-1, ..., and 11-7 each including sixteen bits line BL. The sixteen bit lines BL in the first sub-block 11-0 are connected to the output buffer 31 by way of respective bit-line selecting transistors $T_{a0}$, $T_{a1}$, ..., and $T_{a15}$, a sub-block-selecting transistor $T_{b0}$ and a memory-cell block selecting transistor $T_{c1}$ in the switching circuit 21. Similarly, all of the sixteen bit lines in each of the other sub-blocks 11-1, 11-2, .., and 11-7 are connected through similar bit-line selecting transistors (not shown), a similar sub-block selecting transistor (not shown), and through the memory-cell block selecting transistor $T_{c1}$ in the switching circuit 21, to the same output buffer 31.

The switching circuit 21 further includes an inverter IV1 having an input for receiving the control signal BR1 from the control signal generating circuit 41, and having an output connected to the gate of the transistor $T_{c1}$. The switching circuit 21 still further includes a redundancy-block selecting transistor $T_{c2}$ having a gate connected to the input of the inverter IV1. The sources of the transistors $T_{c1}$ and $T_{c2}$ are connected to the output buffer 31.

Each of the other memory cell blocks 12, 13, ..., and 19 has the same circuit configuration as that of the memory cell block 11.

The respective switching circuits 22, 23, ..., and 28 associated with the memory cell blocks 12, 13, ..., and 18 have the same circuit configuration as that of the switch circuit 21. However, the switching circuit corresponding to the redundancy memory cell block 19 has a single switching transistor $T_{c3}$ whose gate electrode is connected to receive the control signal BR9. The sources of the sub-block selecting transistors $T_{b0}$, $T_{b1}$, ..., and $T_{b7}$ in the redundancy memory cell block 19 are commonly connected through the switching transistor $T_{c3}$ to the drains of the redundancy block selecting transistors $T_{c2}$ in all of the switching circuits 21 to 28.

In each of the sub-blocks of the memory cell blocks 11 to 19, the gate electrodes of the bit-line selecting transistors $T_{a0}$, $T_{a1}$, ..., and $T_{a15}$ are connected to receive bit-line selecting signals B0, B1, ..., and B15, respectively. The bit-line selecting signals B0, B1, ..., and B15 are supplied by a first column decoder circuit 7 which decodes low-order column address input signals A0, A1, A2 and A3 so as to set one of the bit-line selecting signals B0, B1, ..., and B15 to a high potential level "H".

In each of the memory cell blocks 11 to 19, the gate electrodes of the sub-block selecting transistors $T_{b0}$, $T_{b1}$, ..., and $T_{b7}$ are connected to receive sub-block selecting signals C0, C1, ..., and C7, respectively. The sub-block selecting signals C0, C1, ..., and C7 are supplied from a second column decoder circuit 8 which decodes high-order column address signals a4, a5, and a6 so as to set one of the sub-block selecting signals C0, C1, ..., and C7 to a high potential level "H". Thus, by specifying the column address signals A0 to A3 and a4 to a6, one of the eight sub-blocks in each memory-cell block is selected, and one of the sixteen bit lines BL in each of the selected sub-blocks is selected.

The virtual word line VWL is also connected to the row decoder circuit 6 and to an address signal generating circuit 9. When the virtual word line VWL is selected, a reference voltage VRR is applied to the row decoder circuit 6 to inhibit its operation, and to the address signal generating circuit 9 to generate a fixed set of address signals a4, a5, and a6 in response to the control signals BR1 to BR9.

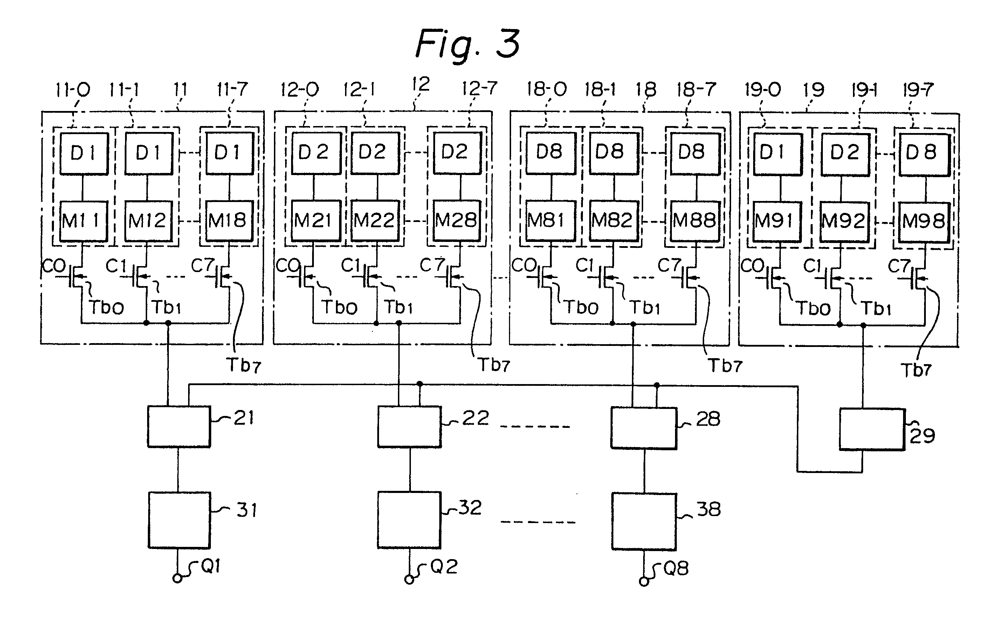

In this embodiment, each of the ROM parts of the sub-blocks in the primary memory cell block stores the same data, as illustrated in Figure 3. Reference symbols D1, D2, ..., and D8 represent respective data items, referred to below as composite data words, derived from the electronic signature data and stored in the memory cell blocks 11 to 19 as shown in Figure 3. Reference symbols M11, M12, ..., M18, M21, M22, ..., M28, ..., M91, M92, ..., and M98 represent data stored in the memory cells MC of the respective sub-blocks 11-0, 11-1, ..., 11-7, 12-0, ..., 12-7, 19-0, ..., and 19-7 shown in Figure 2. As shown in Figure 3, each of the sub-blocks in the memory cell block 11 stores the same composite data word D1. Also, all of the sub-blocks in the memory cell block 12 store the same data D2. Similarly, all of the sub-blocks in each of the memory cell blocks 13 to 18 store the same data D3, D4, .., or D8, respectively. However, in the redundancy memory cell block 19, the sub-blocks 19-0, 19-1, ..., and 19-7 respectively store the data D1, D2, ..., and D8 corresponding to the data stored in the memory cell blocks 11 to 18.

Operation of the circuit shown in Figure 2 will now be described.

When the electronic signature is to be read and the redundancy block is being used in place of a faulty one of the memory cell blocks 11 to 18, the virtual word line VWL is selected by applying an address input signal of 12 V via the address-bit terminal A9 to the signal detecting circuit, and all of the word lines WL are inactive because the row decoder circuit 6 is disabled once the virtual word line VWL is selected. The selected virtual word line VWL supplies the reference voltage VRR to the address signal generating circuit 9. Assuming that the EPROM device has been programmed to cause the redundancy memory cell block 19 to be used in place of primary memory cell block 11, for example, the control signals BR1 and BR9 become "H". In the switching circuit 21 the control signal BR1 is inverted by the inverter IV1 so that the first memory-cell block selecting transistor $T_{c1}$ is turned off, but the uninverted "H" level control signal BR1 is directly applied to the gate of the redundancy-block selecting transistors $T_{c2}$, so that it turns on. Also, the transfer gate transistor $T_{c3}$ in the switching circuit 29 is turned on by the control signal BR9. When the part of the electronic signature data corresponding to that stored in the malfunctioning memory cell block 11 is to be read from the first sub-block of redundancy block 19, it is sufficient to fix the sub-block selecting signal C0 at the "H" level, regardless of address input signals A4 to A6. This fixing operation of the sub-block selecting signal C0 is carried out by means of the address signal generating circuit 9, as described later in detail. Thus, in place of the composite data word D1 stored in the malfunctioning memory cell block 11, the word D1 stored in the ROM part of first sub-block 19-0 of the redundancy memory cell block 19 is transferred through the transistors $T_{c3}$ and $T_{c2}$ to the output buffer 31.

In normal operation of the EPROM shown in Figure 2 (i.e. when it is not required to read electronic signatures or to replace a faulty memory-cell block with the redundancy memory cell block 19) all of the control signals BR1 to BR9 are set at the low potential level "L", and the address input signal A9, i.e., the virtual word line selecting signal, at the address input terminal A9 is not raised to the high potential of 12 V. As a result, the bit line selecting transistors $T_{c1}$ in all of the switching circuits 21 to 28 are conductive, and the transfer gate transistor $T_{c3}$ in the switching circuit 29 is nonconductive. Also, the row decoder circuit 6 decodes row address signals A7, A8, ..., and A17 so as to set one of the word lines WL at high potential level "H", and the virtual word line VWL is not selected. Accordingly, the erasable and programmable memory cells MC are accessed for reading, writing or erasing operations.

When a faulty memory cell block, for example the memory cell block 11 is replaced by the redundancy memory cell block 19 during the accessing of the memory cells MC, the replacing operation is identical to that described above with reference to the reading of electronic signature data, except that in this case the virtual word line VWL is not selected and the address input signals A4 to A6 determine the sub-block selecting signal C0 to C7.

Replacement of any other faulty memory cell block with the redundancy memory cell block 19 can be carried out by pre-programming the corresponding control signal BRi (i = 2, 3, ..., or 8) and the control signal BR9 to be at high potential levels "H".

Figure 4 is a table showing a format of the electronic signatures proposed by JEDEC, and also illustrates how, in an embodiment of the present invention, the sixteen original data words of the electronic signature ES1, ES2, ..., and ES16 are reformatted as composite data words D1 to D8 for storage in the read only memory cells RC of the EPROM shown in Figure 2. Each original data word of the electronic signature consists of 8-bit data. Each bit in such a signature word can be read out from one of the eight output terminals Q1 to Q8. The first signature word ES1 is a manufacturers' code M.C. consisting of 8-bit data $d_{10}$, $d_{20}$, ..., and $d_{80}$. The second signature word ES2 is a programming algorithm code A.C. consisting of 8-bit data $d_{11}$, $d_{21}$, ..., and $d_{81}$. The remaining signature words ES3 to ES16 are defined separately by each manufacturer. In the circuit shown in Figure 2, respective bits $d_{10}$, $d_{20}$, ..., and $d_{80}$ of the 8-bits constituting the first signature word are stored in the memory cell blocks 11 to 18. More precisely, the least significant bit $d_{10}$ is stored in the first read only memory cell RC associated with the first bit line BL which is selected by the bit-line selecting signal B0, in each sub-block of the first memory cell block 11. The second bit $d_{20}$ from the first signature word is stored in the first read only memory cell RC selected by the bit-line selecting signal B0 in each sub-block of the second memory cell block 12. Similarly, the remaining bits $d_{30}$, $d_{40}$, ..., and $d_{80}$ are stored in the first read only memory cells RC selected by the bit-line selecting signal B0, in respective memory cell blocks 13 to 18, respectively.

The 8-bits $d_{11}$, $d_{21}$, ..., and $d_{81}$ of the second signature word ES2 are stored in the second read only memory cells RC selected by the bit-line selecting signal B1, in the memory cell blocks 11 to 18, respectively.

Thus, respective bits of successive electronic signature words are stored in successive read only memory cells in respective memory cell blocks 11 to 18. Accordingly, each of the sub-blocks 11-0 to 11-7 in the first memory cell block 11 stores the sixteen-bit composite data word D1 consisting of the respective first bits $d_{10}$, $d_{11}$, ..., and $d_{215}$. Similarly, each of the remaining memory cell blocks 13 to 18 stores the corresponding sixteen-bit composite data word D3, D4, ... or D8 in all eight sub-blocks.

In the table shown in Figure 4, the most significant bit of each signature word $d_{80}$, $d_{81}$, ..., or $d_{815}$, which is output from the output terminal Q8 marked with an asterisk, is an odd parity bit.

Figure 5 is a table showing various examples of manufacturers' codes for use in the first signature word ES1. In Figure 5, the manufacturers' code for, for example, AMD, is the 8-bit word 000 000 01, and respective bits thereof are output from the output terminals Q1 to Q8. These manufacturers' codes are stored in the ROM parts of each device to enable a user to identify the device concerned.

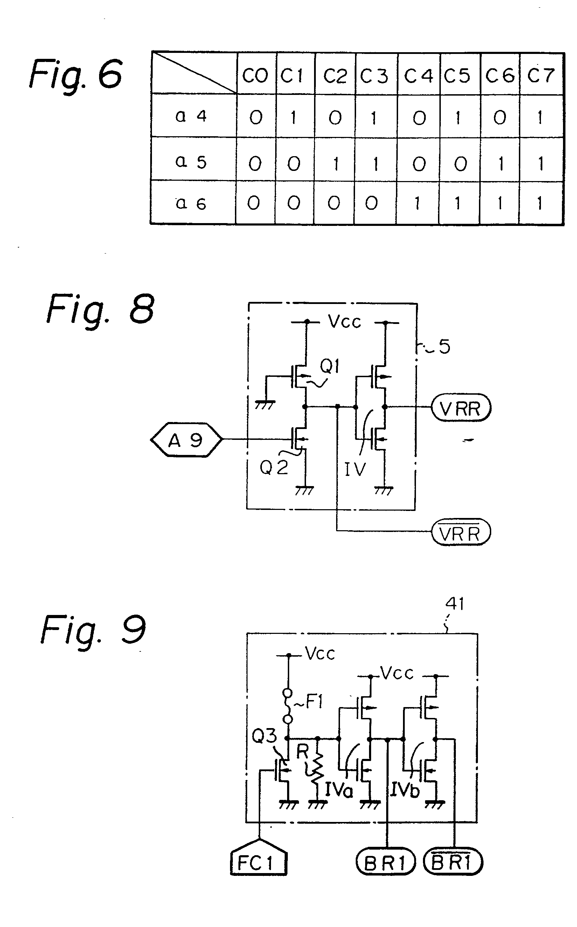

Figure 6 is a table showing the relationship between the high order column address signals a4, a5, and a6, and the selected sub-blocks. In Figure 6, when the column address signals a4, a5, and a6 are 0, 0, and 0, respectively, the sub-block selecting signal C0 is selected at "H" level so that the corresponding sub-blocks 11-0, 12-0, ..., 19-0 (Figure 2) are selected. In this case, if an electronic signature word is being read and the first primary block 11 is faulty, the required signature data from that faulty memory cell block 11 will be replaced by signature data from the first sub-block 19-0 of the redundancy memory cell block 19. Similarly when the column address signals a4, a5, and a6 are 1, 0, 0, respectively, the sub-block selecting signal C1 is set to a "H" level so that the corresponding sub-blocks 11-1, 12-1, ..., and 19-1 are selected. In this case, if an electronic signature word is being read and the second primary block 12 is faulty, the required signature data from that faulty memory cell block 12 will be replaced by signature data from the second sub-block 19-1 of the redundancy memory cell block 19. Other combinations of the column address signals a4, a5, and a6 result in corresponding sub-block selecting signals C2, C3, ..., and C7 being at "H" level. Thus, when signature words are being read, signature data from a faulty block may be replaced by data from the correct sub-block of the redundancy block 19 by causing the column address signals a4, a5, and a6 to have an appropriate set of values, in accordance with Figure 6.

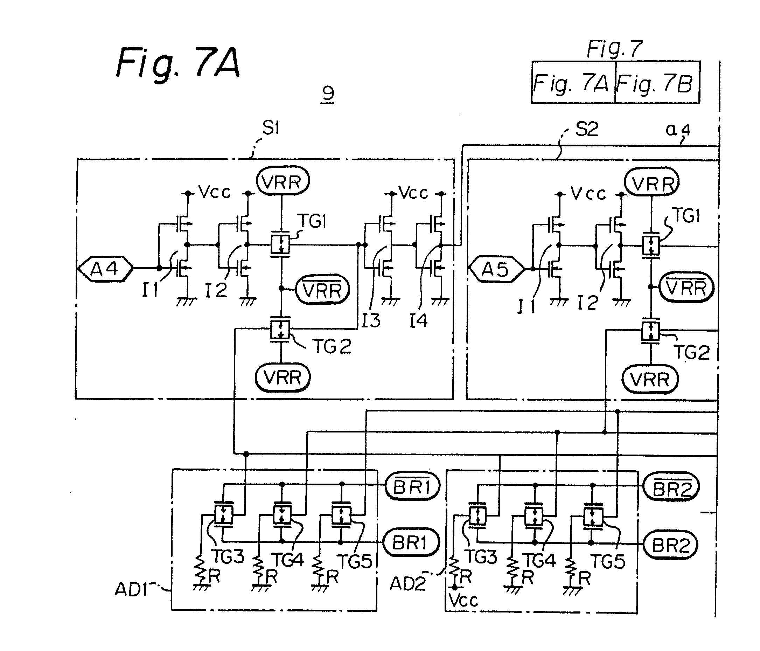

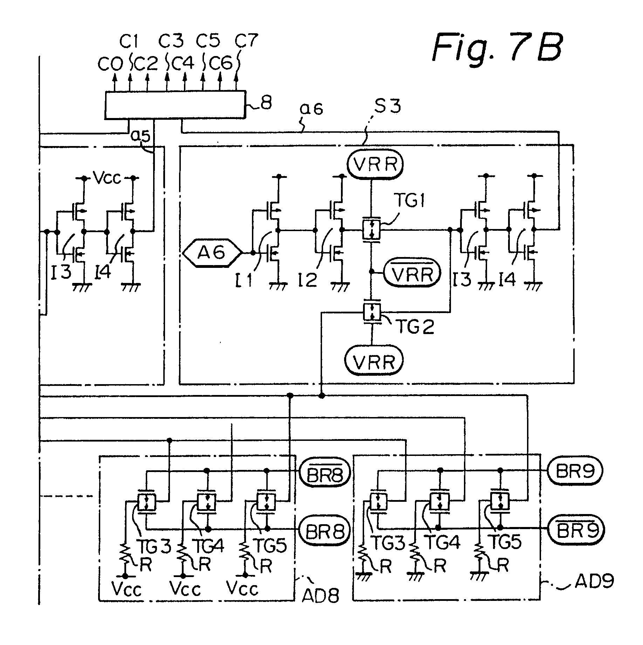

Figure 7 is a circuit diagram illustrating the address signal generating circuit 9 in more detail. In Figure 7, the address signal generating circuit 9 consists of three address signal selecting circuits S1, S2, and S3, and nine address signal determining circuits AD1, AD2, ..., and AD9. Each of the address signal selecting circuits S1, S2, and S3 includes a first pair of inverters I1 to I2, consisting of complementary metal oxide semiconductor (CMOS) transistors, two transfer gates TG1 and TG2, and a second pair of CMOS inverters I3 and I4. The inverters I1 to I4 function as waveform shaping circuits. Each of the transfer gates TG1 and TG2 consists of a P channel metal oxide semiconductor (MOS) transistor and an N channel MOS transistor connected in parallel. Each of the address signal determining circuits AD1 to AD9 includes three transfer gates TG3, TG4, and TG5. Each of the transfer gates TG3, TG4, and TG5 also consists of a P channel MOS transistor and N channel MOS transistor connected in parallel. The outputs of address signal determining circuits AD1 to AD8 determine, when signature data from a faulty block is to be read from the redundancy block, the set of address signals a4, a5, and a6 for setting the appropriate sub-block selecting signal C0, C1, ..., or C7. In such a replacing operation, the respective outputs from transfer gates TG3, TG4, and TG5 of one of the circuits AD1 to AD8 determine the address signals a4, a5, and a6, the circuit concerned being that associated with the primary block that is faulty. To this end, in the address signal determining circuit AD1, all of the inputs of the transfer gates TG3, TG4, and TG5 are connected through resistors R to the ground, so that the circuit AD1 can generate the set (0, 0, 0) of address signals (a4, a5, a6). similarly, in the address signal determining circuits AD2, the input of the transfer gate TG3 is connected through a resistor R to the positive power supply $V_{CC}$, and the other two inputs of the transfer gates TG4 and TG5 are connected through resistors R to the ground, so that the circuit AD2 can generate the set (1, 0, 0) of address signals (a4, a5, a6). Similarly, in the other address signal determining circuits AD3 to AD8, the inputs of the transfer gates TG3, TG4, and TG5 are connected through resistors R to the power supply $V_{CC}$ or to the ground in accordance with the desired set of address signals a4, a5, and a6.

In the operation of the circuit shown in Figure 7, when a signature reading operation is not being carried out, the reference voltage VRR is at the low level "L" because the virtual word line VWL is not selected (see Figure 2). The reference voltage VRR is applied to the gates of the P channel MOS transistors of the transfer gates TG1 and to the gates of the N channel MOS transistors of the transfer gates TG2. The inverted reference voltage VRR is applied to the gate of the N channel MOS transistors of the transfer gates TG1 and to the gates of the P channel MOS transistors of the transfer gates TG2. Therefore, when the reference voltage VRR is at the low level "L", the transfer gates TG1 are conductive and the transfer gates TG2 are nonconductive. As a result, address input signals A4, A5, and A6 applied from an external source are transferred through the transfer gates TG1 in respective address signal selecting circuits S1, S2, and S3 to the second column decoder 8. Thus, the second column decoder 8 receives the external address input signals A4, A5, and A6 as the high order column address signals a4, a5, and a6, respectively.

When, for example the memory cell block 11 is to be replaced by the redundancy memory cell block 19, the control signals BR1 and BR9 are selected at "H" level. The control signal BR1 is applied to the gates of the N channel MOS transistors of the transfer gates TG3, TG4, and TG5 in the first address signal determining circuit AD1. The inverted control signal BR1 is applied to the gates of the P channel MOS transistors of the transfer gates TG3, TG4, and TG5 in the same circuit AD1. Therefore, the transfer gates TG3, TG4, and TG5 in the circuit AD9 are nonconductive. Also, the reference voltage VRR is set to the high level "H" when a signature reading operation is carried out, so that the transfer gates TG1 are nonconductive and the transfer gates TG2 are conductive. As a result, the output of the transfer gate TG3 in the circuit AD1 is transferred through the transfer gate TG2 in the circuit S1 to the second column decoder 8. Since the input of the transfer gate TG3 in the circuit AD1 is grounded through the resistor R, the output thereof is "0", i.e., at the "L" level. Similarly, the outputs of the transfer gates TG4 and TG5 are at the "L" level. Accordingly, the second column decoder 8 receives the address signals a4, a5 and a6 equal to 0, 0, and 0, respectively, regardless of the external address input signals A4, A5, and A6. In response to the address signals 0, 0, and 0, the second column decoder 8 provides the first sub-block selecting signal C0.

Similarly, when the control signal BR2 is set to the "H" level, the second column decoder 8 provides the second sub-block selecting signal C1 during signature reading regardless of the external address inputs signals A4, A5, and A6.

When the control signal BR3, BR4, ..., or BR8 is set to the "H" level, the corresponding sub-block selecting signal C3, C4, ..., or C8 is selected in signature reading operations.

Figure 8 is a circuit diagram showing the signal detecting circuit 5 in more detail. In Figure 8, the signal detecting circuit 5 includes a P channel MOS transistor Q1, an N channel MOS transistor Q2, and an inverter IV. The gate of the transistor Q1 is grounded. The source of the transistor Q1 is connected to the power supply $V_{CC}$. The drain of the transistor Q1 is connected to the drain of the transistor Q2. The source of the transistor Q2 is grounded. The connecting point between the transistors Q1 and Q2 is connected to the input of the inverter IV. The transistor Q2 has a high threshold voltage of slightly less than 12 V, for example 10 V. The gate of the transistor Q2 is connected to the address input terminal A9. When a voltage of 12 V is applied to the address input terminal A9, the transistor Q2 is turned on so that the output of the inverter IV provides the high level "H" of the reference voltage VRR. The inverted reference voltage $\overline{VRR}$ is provided from the input of the inverter IV. The reference voltage VRR is applied to the virtual word line VWL, to the transfer gates in the circuits S1, S2, and S3 (Figure 7), and to the row decoder circuit 6 (Figure 2) for inhibiting its operation.

Figure 9 is a circuit diagram showing the control signal generating circuit 41 in more detail. In Figure 9, the control signal generating circuit 41 includes a fuse F1, an N channel MOS transistor Q3, a resistor R, and two inverters $IV_a$ and $IV_b$. The fuse F1 is connected between the power supply $V_{CC}$ and the drain of the transistor Q3. The source of the transistor Q3 is grounded. The resistor R is connected between the drain of the transistor Q3 and the ground. The drain of the transistor Q3 is connected to the input of the first stage inverter $IV_a$. The output of the first stage inverter $IV_a$ is connected to the input of the second stage inverter $IV_b$. When the fuse blowing signal FC1 is applied to the gate of the transistor Q3, the transistor Q3 turns on so that a current flows through, and blows, the fuse F1, whereupon the drain of the transistor Q3 is pulled down to the "L" level. As a result, the control signal BR1 is obtained at the output of the first stage inverter $IV_a$. Also the inverted control signal $\overline{BR1}$ is obtained at the output of the second stage inverter $IV_b$. The control signal BR1 and the inverted control signal $\overline{BR1}$ are applied to the transfer gates TG3, TG4, and TG5 in the circuit AD1 (Figure 7).

The other control signal generating circuits 42 to 49 have the same circuit configurations as that shown in Figure 9.

Figure 10 is a circuit diagram showing a circuit for generating the fuse-blowing signal FC1. In Figure 10, the circuit includes an input-stage inverter $IV_c$, three P channel MOS transistors Q4, Q5, and Q6, an N channel MOS transistor Q7, and an output-stage inverter $IV_d$. The output of the inverter $IV_c$ is connected to the gates of the transistors Q4 and Q6. The sources of the transistors Q4 and Q6 are connected to the power supply $V_{CC}$. The drains of the transistors Q4 and Q5 are connected to the source of the transistor Q6 and to the input of the inverter $IV_d$. The drain of the transistor Q6 is connected to the drain of the transistor Q7. The source of the transistor Q7 is grounded.

When the replacing signal RW is at the "L" level, the P channel transistor Q5 is conductive and the N channel transistor Q7 is nonconductive, so that the input of the inverter $IV_d$ is at the "H" level. In this case, the fuse-blowing signal FC1 is at the "L" level so that the fuse F1 (Figure 9) is not blown. When the terminal Q1 is at the "L" level and the replacing signal RW is at the "H" level, the transistors Q4 and Q5 are turned off and the transistors Q6 and Q7 are turned on so that the input of the inverter $IV_d$ is at the "L" level. In this case, the fuse-blowing signal FC1 is at the "H" level so as to blow the fuse F1 (Figure 9).

The circuits for generating the fuse-blowing signals FC2 to FC8 have the same circuit configurations as the circuit shown in Figure 10.

As will be apparent, the output terminals Q1 to Q8 are used not only to output read data or to input write data, but also to apply the replaced block selecting signals.

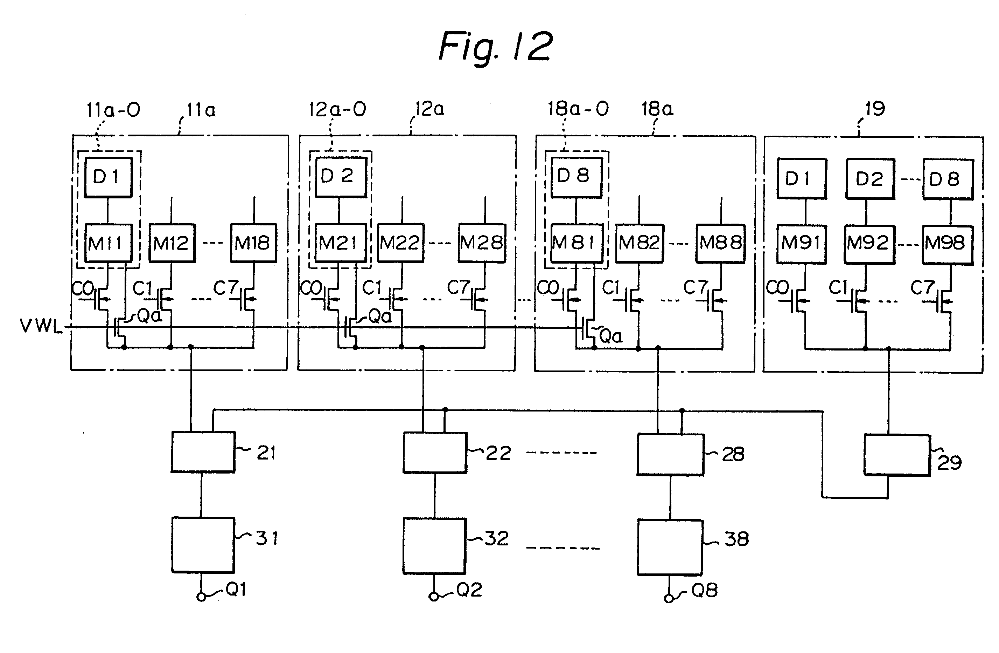

Figure 11 is a circuit diagram showing a circuit for generating the fuse-blowing signal FC9 corresponding to the redundancy block. In Figure 9, the circuit consists of two inverters $IV_e$ and $IV_f$. When the replacing signal RW is at the "H" level, the fuse blowing signal FC9 is turned to the "H" level so as to blow the fuse F9 (not shown).

In the above described embodiment, each of the memory cell blocks 11 through 18 stores eight identical sets of data, each consisting the appropriate composite data word D1, D2, ..., or D8. For example, the memory cell block 11 stores, in its specific area 11a, the eight sets of the sixteen-bit data D1, as illustrated in Figure 3. The present invention, however, is not restricted to the above-described embodiment.

Figure 12 is a block circuit diagram showing an EPROM according to another embodiment of the present invention. In Figure 12, the same reference symbols as those used in Figure 3 denote similar parts. The main difference between Figure 3 and Figure 12 resides in memory cell blocks 11a, 12a, ..., and 18a, such that, in Figure 12, each of the primary memory cell blocks 11a, 12a, ..., and 18a includes, instead of the eight sets, just a single set of the sixteen-bit data D1, D2, ..., or D8 in the first sub-block 11a-0, 12a-0, 13a-0, or 18a-0, respectively. The redundancy memory cell block 19 in Figure 12 is the same as that in Figure 3.

Also, additional respective sub-block selecting transistors $Q_a$ are provided, connected in parallel with the first sub-block selecting transistor $T_{b0}$ in the memory cell blocks 11a to 18a. The gates of the additional sub-block selecting transistors $Q_a$ are connected to the virtual word line VWL.

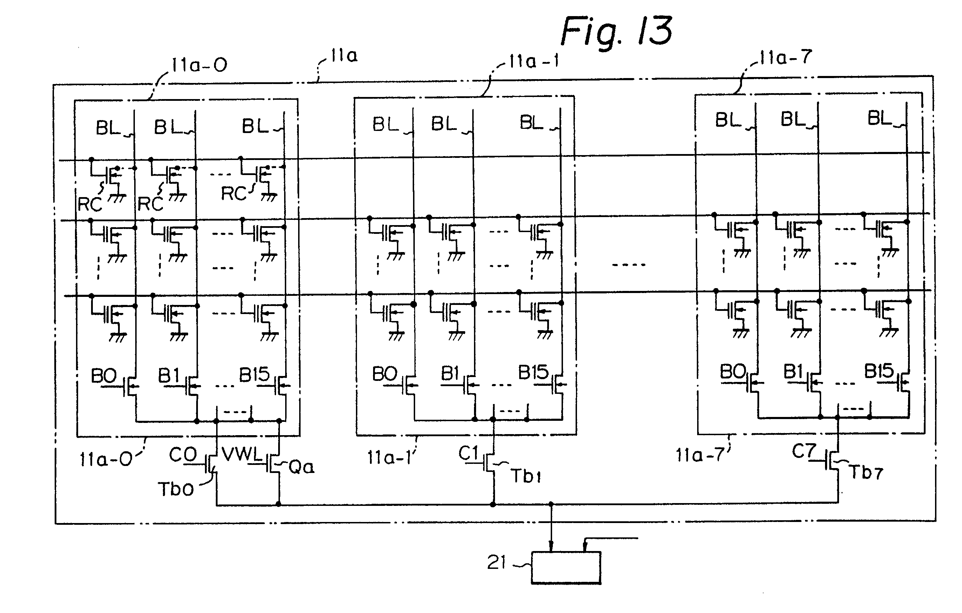

Figure 13 is a circuit diagram showing the memory cell block 11a in the EPROM shown in Figure 12 in more detail. As shown in Figure 13, the read only memory cells RC are provided only in the first sub-block 11a-0 and, the additional sub-block selecting transistor Qa is connected in parallel with the transistor $T_{b0}$.

By virtue of the circuitry illustrated in Figures 12 and 13, when the redundancy memory cell block 19 is not used during reading of the electronic signature, the signature data D1, D2, ..., and D8 contained in the primary blocks is always read from the respective first sub-blocks 11a-0, 12a-0, ..., and 18a-0 of those primary blocks because the virtual word line VWL is set at the "H" level. When the redundancy memory cell block 19 is used during reading of the electronic signature, circuitry as shown in Figure 7 is employed in the same way as in the embodiment of Figure 1.

From the foregoing description, it will be apparent that an embodiment of the present invention can provide a semiconductor memory device having a redundancy structure in which an electronic signature reading circuit is included which can correctly read an electronic signature even when a memory cell block corresponding to any output bit is replaced by a redundancy memory cell block.

The present invention is not restricted to the described embodiments. Various changes and modifications are possible for those skilled in the art. For example, the memory size is arbitrarily chosen. Also, the present invention is applicable not only for an EPROM, but also for a PROM or a random access memory (RAM).

## Claims

1. A semiconductor memory device comprising a plurality of primary memory blocks (11-18), for storing data words in such a manner that respective bits of each word are stored in different memory blocks of the plurality so that a stored data word can be read out in parallel form from respective output points (Q1-Q8) of those memory blocks, and a redundancy memory block (19); the device being selectively programmable to cause the redundancy block to be used in place of any one of the primary memory blocks that is found to be faulty;

characterised in that the said primary and redundancy memory blocks contain, stored in respective ROM parts thereof (11a-19a) lying on one wordline (VWL) of the memory device, predetermined signature data comprising a plural number m of original data words (ES1-ES16), each of n data bits, stored in the form of n composite data words (D1-D8), each made up of m data bits taken respectively from the said original data words, the said n composite data words being stored respectively in the said primary memory blocks, and all of the said n composite data words being stored in the said redundancy block, and in that the device includes signature reading means (9) for accessing data stored in the said ROM parts in such a manner as to read out a selected one of the original data words, the device being such that when programmed to cause the redundancy block to be used, in place of a faulty one of the primary memory blocks, the signature reading means is thereby modified so that, when in operation, it takes from the ROM part of the redundancy memory block that bit of the selected original data word that was stored in the ROM part of the said faulty block.

2. A device as claimed in claim 1, wherein the said signature reading means includes signal detecting circuitry (5), connected to a first wordline address-bit terminal (A9) of the device, for selecting the said one wordline if a voltage greater than a predetermined threshold voltage is applied to the first address terminal.

3. A device as claimed in claim 1 or 2, wherein parts (11b-19b) of the primary and redundancy memory blocks, other than the said ROM parts, comprise erasable and programmable read only memory cells.

4. A method of manufacturing a semiconductor device as claimed in claim 1, 2 or 3, wherein the said memory blocks are tested and, one of them being found to be faulty, the device is then programmed to cause the said redundancy block to be used in place of that faulty primary memory block.

## Revendications

1. Dispositif de mémoire à semiconducteur comprenant une pluralité de blocs de mémoire primaires (11-18) permettant de stocker des mots de données de telle sorte que les bits respectifs de chaque mot soient stockés dans différents blocs de mémoire de la pluralité de blocs de mémoire de manière à ce qu'un mot de données stocké puisse être lu en parallèle depuis des points de sortie respectifs (Q1-Q8) de ces blocs de mémoire, ainsi qu'un bloc de mémoire de redondance (19) ; le dispositif étant programmable sélectivement afin de forcer l'utilisation du bloc de redondance à la place de n'importe lequel des blocs de mémoire primaires qui s'avère être défectueux ;

caractérisé en ce que les blocs de mémoire primaires ainsi que le bloc de mémoire de redondance contiennent, stockées dans leurs parties de mémoire morte (ROM) (11a-19a) qui s'étendent sur une ligne de mot (VWL) du dispositif de mémoire, des données de signature prédéterminées comprenant un multiple m de mots de données originaux (ES1-ES16), chacun des n bits de données, stockés sous la forme de n mots de données composites (D1-D8), chacun étant constitué de m bits de données pris respectivement parmi les mots de données originaux, les n mots de données composites étant respectivement stockés dans les blocs de mémoire primaires et l'ensemble des n mots de données composites étant stocké dans le bloc de redondance et en ce que le dispositif comporte un moyen de lecture de signature (9) qui permet d'accéder aux données stockées dans les parties de la ROM de manière à lire un des mots de données originaux qui a été sélectionné, le dispositif étant tel que, lorsqu'il est programmé pour forcer l'utilisation du bloc de redondance à la place d'un des blocs de mémoire primaire qui s'est avéré défectueux, le moyen de lecture de signature est modifié en conséquence de telle sorte que lorsqu'il fonctionne il prenne dans la partie de la ROM du bloc de mémoire de redondance ce bit du mot de données original sélectionné qui a été stocké dans la Partie de la ROM du bloc défectueux.

2. Dispositif selon la revendication 1, dans lequel le moyen de lecture de signature inclut un circuit de détection de signal (5) connecté à une première borne (A9) du bit d'adresse de la ligne de mot du dispositif pour sélectionner cette ligne de mot si une tension supérieure à une tension de seuil prédéterminée est appliquée à la première borne d'adresse.

3. Dispositif selon la revendication 1 ou 2, dans lequel des parties (11b-19b) des blocs de mémoire primaires ainsi que du bloc de mémoire de redondance, autres que les parties de la ROM, comprennent des cellules de mémoire morte effaçables et programmables.

4. Procédé de fabrication d'un dispositif à semiconducteur selon la revendication 1, 2 ou 3, dans lequel les blocs de mémoire sont testés, et si l'un d'entre eux s'avère défectueux, le dispositif est programmé pour forcer l'utilisation du bloc de redondance à la place du bloc de mémoire primaire défectueux.

## Ansprüche

1. Halbleiterspeichervorrichtung mit einer Vielzahl von primären Speicherblöcken (11-18), zum Speichern von Datenwörtern in solch einer Weise, daß entsprechende Bits von jeden Wort in verschiedenen Speicherblöcken der genannten Vielzahl gespeichert werden, so daß ein gespeichertes Datenwort parallel von entsprechenden Ausgangspunkten (Q1-Q8) jener Speicherblöcke ausgelesen werden kann, und einem Redundanzspeicherblock (19); wobei die Vorrichtung selektiv programmierbar ist, um zu bewirken, daß der Redundanzblock anstelle von irgendeinem der primären Speicherblöcke, der sich als fehlerhaft heraustellt, verwendet werden kann;
dadurch gekennzeichnet, daß die genannten primären und der genannte redundante Speicherblock, in entsprechenden ROM-Teilen (11a-19a) davon, die auf einer Wortleitung (VWL) der Speichervorrichtung liegen, vorbestimmte Signaturdaten enthalten, die eine Vielzahl m von ursprünglichen Datenwörtern (ES1-ES16) umfassen, jedes aus n Datenbits, die in der Form von n zusammengesetzten Datenwörtern (D1-D8) gespeichert sind, die jeweils aus m Datenbits gebildet sind, die jeweils von den genannten ursprünglichen Datenwörtern genommen werden, die genannten n zusammengesetzten Datenwörter jeweils in den genannten primären Speicherblöcken gespeichert werden, und alle der genannten n zusammengesetzten Datenwörter in dem genannten Redundanzblock gespeichert werden, und daß die Vorrichtung Signaturleseeinrichtungen (9) umfaßt, um zu Daten, die in den genannten ROM-Teilen gespeichert sind, in solch einer Weise zuzugreifen, daß ein ausgewähltes der ursprünglichen Datenwörter ausgelesen wird, wobei die Vorrichtung derart ist, daß, wenn sie programmiert ist, um die Benutzung des Redundanzblockes anstelle eines fehlerhaften der genannten primären Speicherblöcke zu bewirken, die Signaturleseeinrichtung dadurch so modifiziert wird, daß sie, wenn sie in Betrieb ist, von dem ROM-Teil des Redundanzspeicherblockes jenes Bit des ausgewählten ursprünglichen Datenwortes nimmt, das in dem ROM-Teil des genannten fehlerhaften Blockes gespeichert war.

2. Vorrichtung nach Anspruch 1, bei dem die Signaturleseeinrichtung eine Signaldetektionsschaltung (5) enthält, die mit einem ersten Wortleitungsadreßbitanschluß (A9) der Vorrichtung verbunden ist, um die genannte eine Wortleitung auszuwählen, wenn eine Spannung größer als eine vorbestimmte Schwellenwertspannung dem ersten Adreßanschluß zugeführt wird.

3. Vorrichtung nach Anspruch 1 oder 2, bei der Teile (11b-19b) der Primär- und Redundanzspeicherblöcke andere als die genannten ROM-Teile, löschbare und programmierbare nur-Lese-Speicherzellen umfassen.

4. Verfahren zur Herstellung einer Halbleitervorrichtung nach Anspruch 1, 2 oder 3, bei der die genannten Speicherblöcke getestet werden, und wenn einer von ihnen als fehlerhaft erkannt wird, die Vorrichtung dann programmiert wird, um zu bewirken, daß der genannte Redundanzblock anstelle jenes fehlerhaften Primärspeicherblockes verwendet wird.

Fig. 1

EP 0 116 464 B1

Fig. 2

Fig. 3

# Fig. 4

OUTPUT

MSB                             LSB

| | | $Q8^*$ | Q7 | Q6 | Q5 | Q4 | Q3 | Q2 | Q1 |
|---|---|---|---|---|---|---|---|---|---|
| ES1 (M.C.) | B0 | $d_{80}$ | $d_{70}$ | $d_{60}$ | $d_{50}$ | $d_{40}$ | $d_{30}$ | $d_{20}$ | $d_{10}$ |
| ES2 (A.C.) | B1 | $d_{81}$ | $d_{71}$ | $d_{61}$ | $d_{51}$ | $d_{41}$ | $d_{31}$ | $d_{21}$ | $d_{11}$ |
| ES3 | B2 | | | | | | | | |
| ES4 | B3 | | | | | | | | |
| | B4 | | | | | | | | |
| | B5 | | | | | | | | |
| | B6 | | | | | | | | |
| | B7 | | | | | | | | |
| | B8 | | | | | | | | |
| | B9 | | | | | | | | |
| | B10 | | | | | | | | |
| | B11 | | | | | | | | |
| | B12 | | | | | | | | |
| | B13 | | | | | | | | |
| | B14 | | | | | | | | |
| ES16 | B15 | $d_{815}$ | $d_{715}$ | $d_{615}$ | $d_{515}$ | $d_{415}$ | $d_{315}$ | $d_{215}$ | $d_{115}$ |

FOR EACH MANUFACTURER

D8   D7   D6   D5   D4   D3   D2   D1

# Fig. 5

| JEDEC | Q8 | Q7 | Q6 | Q5 | Q4 | Q3 | Q2 | Q1 |
|---|---|---|---|---|---|---|---|---|
| 1 AMD | 0 | 0 | 0 | 0 | 0 | 0 | 0 | 1 |
| 2 AMI | 0 | 0 | 0 | 0 | 0 | 0 | 1 | 0 |
| 3 FAIRCHILD | 1 | 0 | 0 | 0 | 0 | 0 | 1 | 1 |
| 4 FUJITSU | 0 | 0 | 0 | 0 | 0 | 1 | 0 | 0 |
| 5 GTE | 1 | 0 | 0 | 0 | 0 | 1 | 0 | 1 |
| 6 HARRIS | 1 | 0 | 0 | 0 | 0 | 1 | 1 | 0 |
| 7 HITACHI | 0 | 0 | 0 | 0 | 0 | 1 | 1 | 1 |
| 8 INNOS | 0 | 0 | 0 | 0 | 1 | 0 | 0 | 0 |
| 9 INTEL | 1 | 0 | 0 | 0 | 1 | 0 | 0 | 1 |
| 10 ITT | 1 | 0 | 0 | 0 | 1 | 0 | 1 | 0 |
| 11 INTERSIL | 0 | 0 | 0 | 0 | 1 | 0 | 1 | 1 |
| 12 MONOLITHIC MEMORIES | 1 | 0 | 0 | 0 | 1 | 1 | 0 | 0 |
| 13 MOSTEK | 0 | 0 | 0 | 0 | 1 | 1 | 0 | 1 |
| 14 MOTOROLA | 0 | 0 | 0 | 0 | 1 | 1 | 1 | 0 |
| 15 NATIONAL | 1 | 0 | 0 | 0 | 1 | 1 | 1 | 1 |
| 16 NEC | 0 | 0 | 0 | 1 | 0 | 0 | 0 | 0 |
| 17 RCA | 1 | 0 | 0 | 1 | 0 | 0 | 0 | 1 |
| 18 RAYTHEON | 1 | 0 | 0 | 1 | 0 | 0 | 1 | 0 |
| 19 ROCKWELL | 0 | 0 | 0 | 1 | 0 | 0 | 1 | 1 |
| 20 SEEQ | 1 | 0 | 0 | 1 | 0 | 1 | 0 | 0 |
| 21 SIGNETICS | 0 | 0 | 0 | 1 | 0 | 1 | 0 | 1 |
| 22 SYNERTEK | 0 | 0 | 0 | 1 | 0 | 1 | 1 | 0 |
| 23 TEXAS INSTRUMENTS | 1 | 0 | 0 | 1 | 0 | 1 | 1 | 1 |
| 24 TOSHIBA | 1 | 0 | 0 | 1 | 1 | 0 | 0 | 0 |
| 25 XICOR | 0 | 0 | 0 | 1 | 1 | 0 | 0 | 1 |
| 26 ZILOG | 0 | 0 | 0 | 1 | 1 | 0 | 1 | 0 |

## Fig. 6

| | CO | C1 | C2 | C3 | C4 | C5 | C6 | C7 |
|---|---|---|---|---|---|---|---|---|
| a 4 | O | 1 | O | 1 | O | 1 | O | 1 |
| a 5 | O | O | 1 | 1 | O | O | 1 | 1 |
| a 6 | O | O | O | O | 1 | 1 | 1 | 1 |

## Fig. 8

## Fig. 9

Fig. 7A

Fig. 7

| Fig. 7A | Fig. 7B |
|---------|---------|

EP 0 116 464 B1

Fig. 7B

# Fig. 10

# Fig. 11

# Fig. 12

EP 0 116 464 B1

Fig. 13